# EUROPÄISCHE PATENTSCHRIFT

(11) **EP 2 474 255 B1**
(45) Veröffentlichungstag und Bekanntmachung des Hinweises auf die Patenterteilung: **07.05.2014**
(21) Anmeldenummer: 11009758.1
(22) Anmeldetag: 10.12.2011
(51) Int. Cl.: A47J 31/52, G07F 9/02, H03K 17/96

(54) **Steuerungsvorrichtung für Elektrogeräte**
Control device for electric devices
Dispositif de commande pour appareils électriques

(30) Priorität: 07.01.2011 DE 102011008096
(43) Veröffentlichungstag der Anmeldung: 11.07.2012
(73) Patentinhaber: Severin Elektrogeräte GmbH, 59846 Sundern (DE)
(72) Erfinder: Hilckmann, Marius, 58453 Witten (DE)
(74) Vertreter: Köchling, Conrad-Joachim

(56) Entgegenhaltungen:
- EP-A1- 1 992 263
- EP-A1- 2 111 779
- WO-A1-03/037151
- WO-A1-2007/003062

## Beschreibung

Die Erfindung betrifft eine Steuerungsvorrichtung für Elektrogeräte, insbesondere Kaffeemaschinen, aufweisend zumindest eine Eingabeeinheit und eine Anzeigeeinheit der mit der Eingabeeinheit ausgewählten Funktion, wobei durch die Steuerungsvorrichtung diverse Funktionen über eine Betätigung entsprechender Schaltelemente am Elektrogerät aktivierbar sind, wobei die Eingabeeinheit zwei berührungssensitive Schaltflächen aufweist, die nahe der Anzeigeeinheit angeordnet sind und zur Auswahl der auf der Anzeigeeinheit dargestellten Funktionen dienen, wobei ferner die erste berührungssensitive Schaltfläche eine auf der Anzeigeeinheit dargestellte Funktion auswählt und die zweite berührungssensitive Schaltfläche die Funktion bestätigt oder gegebenenfalls variiert.

Derartige Steuerungsvorrichtungen sind im Stand der Technik bekannt. So ist beispielsweise aus der EP 2 111 779 A 1 eine automatische Kaffeemaschine mit einem Bedienfeld, dass eine Benutzerschnittstelle aufweist, die aus einer Mehrzahl von kapazitiven Sensoren zum Erzeugen von Signalen zum Steuern und/oder Programmieren genannter Kaffeemaschine besteht, bekannt. Bei dieser bekannten Lösung umfasst die genannte Schnittstelle eine auf einer Auflage für die kapazitiven Sensoren aufgesetzte Maske und die Maske spezifische mit Identifizierungszeichen einer Programmier- und/oder Steuerfunktion angezeigte Erfassungsbereiche.

Dabei liegt jeder dieser Erfassungsbereiche an einer Elektrode eines entsprechenden kapazitiven Sensors auf, wobei die Auflage eine biegsame gedruckte Schaltung ist, die die genannte Elektrode der genannten kapazitiven Sensoren und leitfähige Spuren mit Endkontakten aufweist, die an einen Verbinder einer elektronischen Kontrollkarte der Kaffeemaschine angeschlossen sind. Somit bildet bei dieser Lösung das Bedienfeld eine Art Touchscreen, welches in der Herstellung aufwendig und kostenintensiv ist.

Aus der WO 03/037 151 A 1 ist eine Steuerungsvorrichtung für Elektrogeräte ähnlicher Art bekannt.

Bei weiteren im Stand der Technik bekannten Lösungen sind die Verwendung von berührungssensitiven Anzeige-und Eingabeeinheiten (Touchscreens) in verschiedenen Ausführungen bekannt.

Derartige Touchscreens sind in der Herstellung kostenintensiv und dabei häufig anfällig für Beschädigungen oder Zerstörungen durch unsachgemäße Benutzung.

Aufgrund des eingangs genannten Standes der Technik liegt der vorliegenden Erfindung die Aufgabe zugrunde, eine Steuerungsvorrichtung der eingangs genannten Art zu schaffen, die zum einen eine intuitive Bedienung auch von einem unerfahrenen Benutzer ermöglicht, die des Weiteren eine möglichst große Anzeigeeinheit aufweist, die dabei kostengünstig und einfach zu fertigen ist und eine hohe Lebensdauer aufweist.

Zur Lösung dieser Aufgabe schlägt die Erfindung vor, dass an der Steuerungsvorrichtung von der Anzeigeeinheit und den berührungssensitiven Schaltflächen unabhängige, beleuchtete Symbole nahe den berührungssensitiven Schaltflächen oder die berührungssensitiven Schaltflächen zumindest teilweise überdeckend angeordnet sind, die die Aufmerksamkeit des Bedieners auf die berührungssensitiven Schaltflächen lenken.

Weitere vorteilhafte Weiterbildungen der Erfindung sind in den Unteransprüchen beschrieben.

Bei einer erfindungsgemäßen Steuerungsvorrichtung kann der Benutzer mittels Betätigung der als Slider ausgebildeten berührungssensitiven Schaltflächen, die Slider sowohl zur Auswahl und Einstellung als auch, durch Emulation mehrerer Tastenfunktionen über den Bereich des Sliders, zur Bestätigung der jeweiligen Funktion der Vorrichtung verwenden.

Die Anordnung jeweils eines Sliders neben und unter der Anzeigeeinheit, die eine etwa rechteckige Form aufweist, ermöglicht eine intuitive Bedienung. Die Führung des Benutzers wird durch eine Beleuchtung von hinten, bei der jeweils aktive Elemente optisch hervorgehoben werden, unterstützt.

Um eine besonders einfache und intuitive Bedienung der Steuerungsvorrichtung zu ermöglichen, sind an oder nahe an den berührungssensitiven Schaltflächen der Slidern, die berührungssensitiven Schaltflächen beziehungsweise Slider zumindest teilweise überdeckend beleuchtete Symbole angeordnet. Die beleuchteten Symbole sind durch einen Pfeil oder eine Hand mit ausgestrecktem Zeigefinger als Richtungspfeil gebildet und unmittelbar über beziehungsweise neben der berührungssensitiven Schaltfläche beziehungsweise dem Slider angeordnet. Hierdurch wird die Aufmerksamkeit des Bedieners unmittelbar auf die Bedienelemente selbst, und nicht auf die Anzeigeeinheit gelenkt.

Somit ist eine falsche Bedienung, beispielsweise durch Berühren der Anzeigeeinheit und dem Versuch, hiermit eine Funktion auszuwählen oder zu bestätigen, weitestgehend vermieden, da durch die beleuchteten Symbole auch dem ungeübten Benutzer auf einfache Art und Weise mitgeteilt wird, an welchen Stellen Funktionen auszuwählen oder zu bestätigen sind.

Das Hauptmenü zur Bedienung kann dabei durch eine weitere berührungssensitive Schaltfläche aktiviert beziehungsweise deaktiviert werden. Die weitere berührungssensitive Schaltfläche befindet sich nahe der Anzeigeeinheit und ist entsprechend gekennzeichnet, gegebenenfalls ständig
hinterleuchtet.

Eine Getränkeauswahl erfolgt im Hauptmenü über das Selektieren einer auf der Anzeigeeinheit dargestellten Funktion. Jeder Funktion ist ein entsprechendes Icon zugeordnet. Diese können aufgrund der geometrischen Anordnung besonders günstig im unteren Bereich der Anzeigeeinheit nebeneinander dargestellt werden und mittels des unterhalb der Anzeigeeinheit angeordneten Sliders beziehungsweise der berührungssensitiven Schaltfläche ausgewählt werden. Dabei wird das jeweils ausgewählte Icon mittig dargestellt und dabei optisch hervorgehoben beziehungsweise vergrößert.

Die optische Hervorhebung kann beispielsweise durch eine Umrahmung der ausgewählten Funktion erfolgen. Auch kann die ausgewählte Funktion zur optischen Hervorhebung beispielsweise dreidimensional auf der Anzeigeeinheit dargestellt werden, um den Benutzer das jeweils ausgewählte Icon besonders hervorzuheben.

Dabei entsteht für den Bediener der Eindruck, als würde er die zur Auswahl stehenden, durch ein Icon dargestellten, Funktionen in einem räumlichen Umfeld hin- und her bewegen. Dies kann beispielsweise durch einen optisch dargestellten Tisch erfolgen, auf dem die ausgewählten Icons im Kreis umhergeschoben werden können.

Weitere Detailinformationen zum ausgewählten Getränk sowie zu ausgewählten Getränkeparametern befinden sich zusätzlich in textueller Form in einem Textfeld, beispielsweise im oberen linken Feld der Anzeigeeinheit. Eine weitere berührungssensitive Schaltfläche, welche außerhalb der Anzeigeeinheit, nahe der Anzeigeeinheit angeordnet ist, ermöglicht den Start und gegebenenfalls ein Unterbrechen der Getränkezubereitung. Diese berührungssensitive Schaltfläche kann auch zum Starten eines Programmier- oder Einstellmenüs, welches auf der Anzeigeeinheit dargestellt wird, Verwendung finden. Hierzu muss die berührungssensitive Schaltfläche beispielsweise für eine längere Zeitdauer betätigt werden, um versehentliche Fehlbedienungen zu vermeiden. In dem so gewählten Programmier-/Einstellmenü können aus einer Vielzahl von textuellen Einträgen Parameter intuitiv ausgewählt und mit dem jeweiligen Slider bestätigt beziehungsweise variiert werden, wodurch auch das Programmieren einer derartigen Steuerungsvorrichtung stark vereinfacht ist.

Besonders vorteilhaft ist hierbei die Möglichkeit, die berührungssensitiven Schaltflächen beziehungsweise Slider auch zur Einstellung von Werten aus Wertebereichen zu verwenden. So kann beispielsweise eine sich füllende Taste zur Visualisierung bei der Einstellung der Tassenfüllmenge verwendet werden. Hierfür besonders geeignet ist der vertikal neben der Anzeigeeinheit angeordnete Slider, welcher mit einer optisch dargestellten Bewegung nach oben den Füllstand einer Tasse anzeigt.

### Eine derartige erfindungsgemäße

Steuerungsvorrichtung besteht im Wesentlichen aus einem vorzugsweise farbigen Graphikdisplay als Anzeigeeinheit und daneben angeordneter berührungssensitiver Schaltflächen. Die Schaltflächen können durch Tastenfelder in den Eckbereichen der Anzeigeeinheit und durch berührungssensitive Slider, welche entlang der Randkanten der Anzeigeeinheit angeordnet sind, bestehen. Die Slider bieten dabei kontextsensitiv unterschiedliche Bedienfunktionalitäten. Sie können eine oder mehrere Tasten emulieren, beispielsweise zur Bestätigung einer angezeigten Funktion, oder aber der Auswahl eines Elementes aus einer Menge von Elementen beziehungsweise der Einstellung eines Parameters aus einem Parameterbereich im Programmier-/Einstellmenü dienen. Die optische Unterstützung durch die beleuchteten Symbole verhindert die fälschliche Annahme, dass es sich bei der Anzeigeeinheit um einen Touch-Screen handeln könnte. Zudem helfen die optisch hervorgehobenen Symbole auch einem unerfahrenen Benutzer bei der intuitiven Bedienung der Steuerungsvorrichtung.

Mittels der auf der Anzeigeeinheit dargestellten wesentlichen Parameter in textueller und graphischer Form können mögliche Veränderungen der Funktionen beispielsweise Getränkemenge, Getränkestärke durch Hinzufügen von Zutaten wie beispielsweise Zucker, Süßstoff, Milch oder ähnlichem durch einfaches Auswählen mittels der seitlich neben der Anzeigeeinheit angeordneten Slider und gegebenenfalls Bestätigen durch die berührungssensitive Schaltfläche erfolgen. Dabei kann die Bestätigung durch eine zusätzlich zu den Slidern angeordnete berührungssensitive Schaltfläche oder aber durch ein auf dem Slider angeordnetes Symbol, welches einer speziellen Funktion zugeordnet ist, erfolgen.

Zur besonderen Hervorhebung der Auswahl kann das die ausgewählte Funktion beziehungsweise das ausgewählte Getränk dreidimensional auf der Anzeigeeinheit dargestellt werden, so dass der Bediener jederzeit weiß, was er gerade ausgewählt hat. Zur näheren Erläuterung können weitere Detailangaben, wie beispielsweise das Hinzufügen von Zutaten wie Zucker, Milch und so weiter symbolisch und/oder textuell neben der 3-dimensionalen Darstellung erfolgen.

### In einem besonders bevorzugten

Ausführungsbeispiel erfolgt die Bestätigung zur Ausgabe des ausgewählten Getränks durch eine dedizierte berührungssensitive Schaltfläche. Die gleiche berührungssensitive Schaltfläche kann beispielsweise durch Betätigung über einen längeren vorbestimmten Zeitraum auch zum Aktivieren eines Programmier-/Einstellmenüs der Steuerungsvorrichtung dienen.

Ein Ausführungsbeispiel der Erfindung ist in den Zeichnungen dargestellt und im Folgenden näher beschrieben.

Es zeigt:

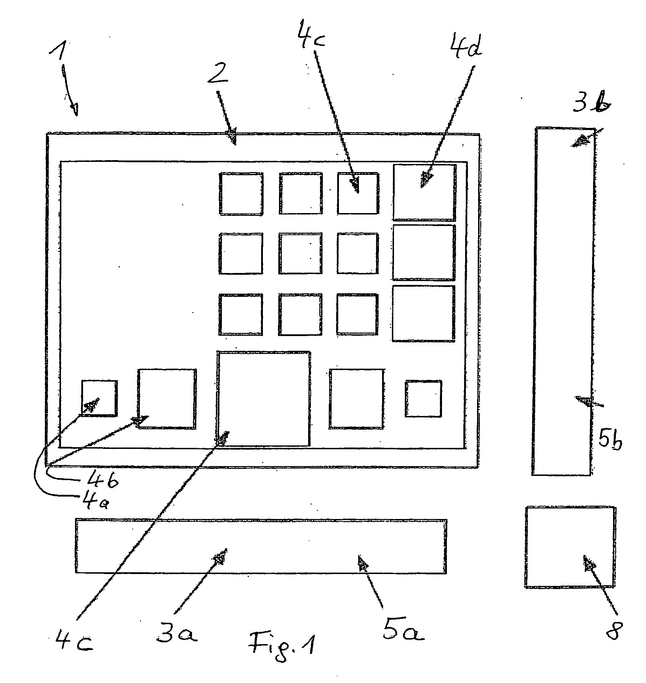

- Figur 1: ein erstes Ausführungsbeispiel eine erfindungsgemäßen Steuerungsvorrichtung;
- Figur 2: einen schematischen Ablauf der Bedienung einer Steuerungsvorrichtung.

In den Figuren ist eine Steuerungsvorrichtung 1 für Elektrogeräte gezeigt. Eine derartige Steuerungsvorrichtung 1 findet insbesondere an Kaffeemaschinen oder Kaffeevollautomaten Verwendung. Die Steuerungsvorrichtung 1 umfasst zumindest eine Eingabeeinheit und eine Anzeigeeinheit 2, zur Darstellung der mit der Eingabeeinheit ausgewählten Funktion. Dabei sind durch die Steuerungsvorrichtung 1 diverse Funktionen über eine Betätigung entsprechender Schaltelemente am Elektrogerät beziehungsweise an der Kaffeemaschine aktivierbar.

Erfindungsgemäß weist die Eingabeeinheit zwei berührungssensitive Schaltflächen 3a, 3b auf. Die berührungssensitiven Schaltflächen 3a, 3b sind nahe der Anzeigeeinheit 2 angeordnet und dienen zur Auswahl der auf der Anzeigeeinheit 2 dargestellten Funktionen 4a, 4b, 4c, 4d, 4e. Dabei wählt die erste berührungssensitive Schaltfläche 3a eine auf der Anzeigeeinheit 2 dargestellte Funktion 4a, 4b, 4c, 4d, 4e aus und die zweite berührungssensitive Schaltfläche 3b bestätigt oder variiert die gewählte Funktion 4a, 4b, 4c, 4d, 4e.

An der Steuerungsvorrichtung 1 sind von der Anzeigeeinheit 2 und dem berührungssensitiven Schaltflächen 3a, 3b unabhängige beleuchtete Symbole, die berührungssensitiven Schaltflächen 3a, 3b zumindest teilweise überdeckend angeordnet. Alternativ können die beleuchteten Symbole 5a, 5b, 7 auch nahe den berührungssensitiven Schaltflächen 3a, 3b angeordnet sein. Die beleuchteten Symbole 5a, 5b, 7 lenken die Aufmerksamkeit des Bedieners auf die berührungssensitiven Schaltflächen 3a, 3b und ermöglichen dem Bediener somit eine intuitive Bedienung der Steuerungsvorrichtung 1.

Im Ausführungsbeispiel sind alle
berührungssensitiven Schaltflächen 3a, 3b und gegebenenfalls 6 und 8 durch kapazitive Berührungssensoren gebildet. Dabei sind die berührungssensitiven Schaltflächen 3a, 3b durch Slider gebildet. Die Anzeigeeinheit 2 weist eine etwa rechteckige Form auf. Dabei ist die längere Seite der Rechteckform etwa parallel zu einer ersten Randkante des Gehäuses der Vorrichtung 1 und die kürzere Randkante der Rechteckform etwa parallel zu einer zweiten Randkante des Gehäuses der Vorrichtung 1 angeordnet. Die erste berührungssensitive Schaltfläche 3a ist etwa parallel zu der ersten Randkante und die zweite berührungssensitive Schaltfläche 3b etwa parallel zu der zweiten Randkante der Rechteckform der Anzeigeeinheit angeordnet, im Ausführungsbeispiel nahe benachbart.

Die Schaltflächen 3a, 3b sind dabei in einem Eckbereich, im Ausführungsbeispiel im dem Benutzer zugewandten vorderen rechten Eckbereich der etwa rechteckigen Anzeigeeinheit 2 einander zugeordnet. Die Länge der jeweiligen berührungssensitiven Schaltfläche 3a, 3b entspricht dabei etwa der Länge der daneben angeordneten Randkante der rechteckigen Anzeigeeinheit 2. Zur Aktivierung beziehungsweise zur Deaktivierung der Steuerungsvorrichtung 1 ist im Ausführungsbeispiel nahe der Anzeige 2 eine weitere berührungssensitive Schaltfläche 6 angeordnet. Hierdurch kann auf schnelle und einfache Art und Weise die Steuerungsvorrichtung 1 aktiviert beziehungsweise deaktiviert werden, so dass beispielsweise bei Nichtbenutzung eine Abschaltung erfolgt, um Strom zu sparen.

Im Ausführungsbeispiel ist eine weitere berührungssensitive Schaltfläche 8 zum Start der Getränkeausgabe und/oder zur Aktivierung beziehungsweise Deaktivierung eines Programmier-/Einstellmenüs der Steuerungsvorrichtung 1 angeordnet. Die weitere berührungssensitive Schaltfläche 8 ist im Ausführungsbeispiel im Bereich der einander zugewandten ersten und zweiten berührungssensitiven Schaltflächen 3a, 3b angeordnet.

Auf der Anzeigeeinheit 2 ist die auf der Anzeigeeinheit 2 angezeigte Funktion 4a,4b,4c,4d,4e nach Auswahl durch die entsprechende berührungssensitive Schaltfläche durch eine 3-dimensionale Darstellung optisch hervorgerufen. Alternativ könnte auch eine vergrößerte Darstellung der Auswahl erfolgen.

Die beleuchteten Symbole 5a, 5b, 7 sind im Ausführungsbeispiel durch eine Hand mit ausgestrecktem Zeigefinger als Richtungspfeil gebildet, können alternativ aber auch durch einen Pfeil oder eine ähnliche symbolhafte Hervorhebung bestehen.

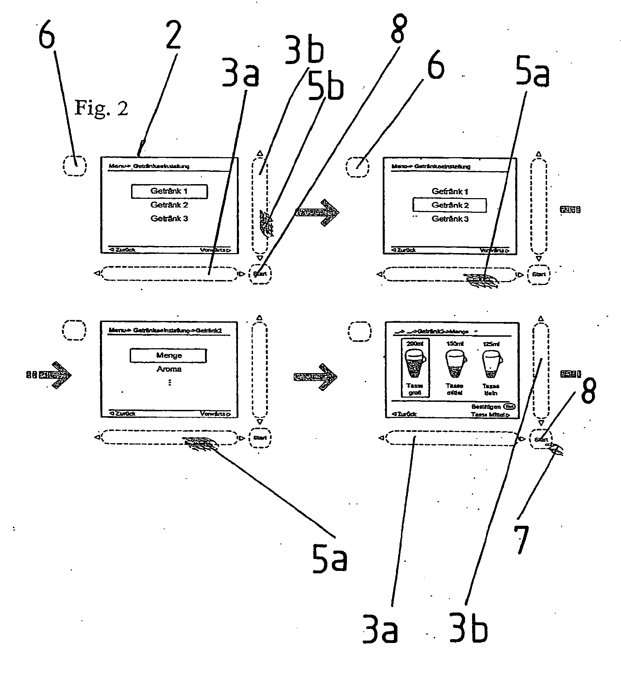

In Figur 2 ist ein schematischer Ablauf einer Auswahl und Bestätigung verschiedener Funktionen (4a, 4b, 4c, 4d, 4e) und Variationen in Richtung der verlaufenden Pfeile gezeigt. Im ersten, in Figur 2 links oben dargestellten Menüpunkt kann durch Betätigung des rechten, vertikal angeordneten Sliders 3a die Auswahl eines entsprechenden Getränkes aus einer Mehrzahl verschiedener Getränke erfolgen. Entsprechend der Pfeilrichtung erfolgt die Auswahl auf Getränk 2 der rechts oben in Figur 2 dargestellten Menüansicht. Anschließend kann durch Betätigung des horizontalen, unterhalb der Anzeigeeinheit 2 angeordneten Sliders 3 b die Auswahl beispielsweise durch Wahl einer entsprechenden Menge, eines Aromas oder dergleichen Variationen verändert werden. Hierzu wird entsprechend der untere Slider 3a betätigt. Abschließend kann die Wahl durch die Betätigung der berührungssensitiven Schaltfläche 8 zur Getränkausgabe erfolgen. Die jeweiligen Auswahlmöglichkeiten sind durch die beleuchteten Symbole 5a, 5b, 7 in Form einer Hand mit ausgestrecktem Zeigefinger als Richtungspfeil gebildet und weisen den Benutzer darauf hin, an welcher Stelle die nächste Auswahl beziehungsweise Eingabe erfolgen muss.

Die Erfindung wie in den Ansprüchen definiert, ist nicht auf dasAusführungsbeispiel beschränkt, sondern im Rahmen der Offenbarung vielfach variabel.

Alle neuen, in der Beschreibung und/oder Zeichnung offenbarten Einzel- und Kombinationsmerkmale werden als erfindungswesentlich angesehen.

## Patentansprüche

1. Steuerungsvorrichtung (1) für Elektrogeräte, insbesondere Kaffeemaschinen, aufweisend zumindest eine Eingabeeinheit und eine Anzeigeeinheit (2) der mit der Eingabeeinheit ausgewählten Funktion, wobei durch die Steuerungsvorrichtung (1) diverse Funktionen über eine Betätigung entsprechender Schaltelemente am Elektrogerät aktivierbar sind, wobei die Eingabeeinheit zwei berührungssensitive Schaltflächen (3a,3b) aufweist, die nahe der Anzeigeeinheit (2) angeordnet sind und zur Auswahl der auf der Anzeigeeinheit (2) dargestellten Funktionen (4a,4b,4c,4d,4e) dienen, wobei ferner die erste berührungssensitive Schaltfläche (3a) eine auf der Anzeigeeinheit (2) dargestellte Funktion (4a,4b,4c,4d,4e) auswählt und die zweite berührungssensitive Schaltfläche (3b) die Funktion (4a,4b,4c,4d,4e) bestätigt oder gegebenenfalls variiert, **dadurch gekennzeichnet, dass** an der Steuerungsvorrichtung (1) von der Anzeigeeinheit (2) und den berührungssensitiven Schaltflächen (3a,3b) unabhängige, beleuchtete Symbole (5a,5b,7) nahe den berührungssensitiven Schaltflächen (3a,3b) oder die berührungssensitiven Schaltflächen (3a,3b) zumindest teilweise überdeckend angeordnet sind, die die Aufmerksamkeit des Bedieners auf die berührungssensitiven Schaltflächen (3a,3b) lenken.

2. Steuerungsvorrichtung (1) nach Anspruch 1, **dadurch gekennzeichnet, dass** die berührungssensitiven Schaltflächen (3a,3b) durch kapazitive Berührungssensoren gebildet sind.

3. Steuerungsvorrichtung (1) nach Anspruch 1 oder 2, **dadurch gekennzeichnet, dass** die Anzeigeeinheit (2) eine etwa rechteckige Form aufweist, wobei die längere Seite der Rechteckform etwa parallel zu einer ersten Randkante des Gehäuses der Vorrichtung und die kürzere Randkante der Rechteckform etwa parallel zu einer zweiten Randkante des Gehäuses der Vorrichtung (1) angeordnet ist, wobei die erste berührungssensitive Schaltfläche (3a) etwa parallel zu der ersten Randkante und die zweite berührungssensitive Schaltfläche (3b) etwa parallel zu der zweiten Randkante der Rechteckform der Anzeigeeinheit (2) angeordnet, vorzugsweise nahe benachbart, ist.

4. Steuerungsvorrichtung (1) nach Anspruch 3, **dadurch gekennzeichnet, dass** die benachbarten Schaltflächen (3a,3b) in einem Eckbereich, vorzugsweise dem Benutzer zugewandten vorderen rechten Eckbereich, der etwa rechteckigen Anzeigeeinheit (2) einander zugeordnet sind.

5. Steuerungsvorrichtung (1) nach einem der Ansprüche 1 bis 4, **dadurch gekennzeichnet, dass** die erste (3a) und / oder die zweite (3b) berührungssensitive Schaltfläche durch einen Slider gebildet ist.

6. Steuerungsvorrichtung (1) nach einem der Ansprüche 3 bis 5, **dadurch gekennzeichnet, dass** die Länge der jeweiligen berührungssensitiven Schaltfläche (3a.3b) jeweils etwa der Länge der daneben angeordneten Randkante der Anzeigeeinheit (2) entspricht.

7. Steuerungsvorrichtung (1) nach einem der Ansprüche 1 bis 6, **dadurch gekennzeichnet, dass** eine weitere berührungssensitive Schaltfläche (6) zur Aktivierung beziehungsweise zur Deaktivierung der Steuerungsvorrichtung (1) nahe der Anzeigeeinheit (2) angeordnet ist.

8. Steuerungsvorrichtung (1) nach einem der Ansprüche 1 bis 7, **dadurch gekennzeichnet, dass** eine weitere berührungssensitive Schaltfläche (8) zum Start der Getränkeausgabe und / oder zur Aktivierung beziehungsweise zur Deaktivierung eines Programmier- / Einstellmenues der Steuerungsvorrichtung (1) nahe der Anzeigeeinheit (2), vorzugsweise im Bereich der einander zugewandten ersten (3a) und zweiten (3b) berührungssensitiven Schaltfläche, angeordnet ist.

9. Steuerungsvorrichtung (1) nach einem der Ansprüche 1 bis 8, **dadurch gekennzeichnet, dass** die auf der Anzeigeeinheit (2) angezeigte Funktion nach Auswahl durch die entsprechende berührungssensitive Schaltfläche (3a,3b) optisch hervorgerufen, insbesondere vergrößert und / oder dreidimensional dargestellt ist.

10. Steuerungsvorrichtung (1) nach einem der Ansprüche 1 bis 9, **dadurch gekennzeichnet, dass** die beleuchteten Symbole (5a,5b,7) durch einen Pfeil oder eine Hand mit ausgestrecktem Zeigefinger als Richtungspfeil bestehen.

## Claims

1. A control device (1) for electrical devices, in particular coffee machines, comprising at least one input unit and one display unit (2), the mode of operation of which is selected by means of the input unit, the control device (1) allowing to activate various functions by actuation of corresponding switching elements at the electrical device, the input unit having two touch-sensitive buttons (3a, 3b) which are arranged close to the display unit (2) and are used for the selection of the functions (4a, 4b, 4c, 4d, 4e) shown on the display unit (2), further the first touch-sensitive button (3a) selecting a function (4a, 4b, 4c, 4d, 4e) shown on the display unit (2), and the second touch-sensitive button (3b) confirming or optionally varying the function (4a, 4b, 4c, 4d, 4e), **characterized in that** at the control device (1) of the display unit (2) and the touch-sensitive buttons (3a, 3b), independent, illuminated symbols (5a, 5b, 7) are arranged close to the touch-sensitive buttons (3a, 3b) or at least partially covering the touch-sensitive buttons (3a, 3b) which direct the attention of the user to the touch-sensitive buttons (3a, 3b).

2. The control device (1) according to claim 1, **characterized in that** the touch-sensitive buttons (3a, 3b) are formed by capacitive touch sensors.

3. The control device (1) according to claim 1 or 2, **characterized in that** the display unit (2) has an approximately rectangular shape, the longer side of the rectangle being arranged approximately in parallel to a first peripheral edge of the housing of the device and the shorter edge of the rectangle being arranged approximately in parallel to a second peripheral edge of the housing of the device (1), wherein the first touch-sensitive button (3a) is arranged approximately in parallel to the first peripheral edge and the second touch-sensitive button (3b) is arranged approximately in parallel to the second peripheral edge of the rectangular shape of the display unit (2), preferably is closely adjacent.

4. The control device (1) according to claim 3, **characterized in that** the adjacent buttons (3a, 3b) are arranged in a corner region, preferably the front right-hand corner region facing toward the user, of the approximately rectangular display unit (2) .

5. The control device (1) according to one of claims 1 to 4, **characterized in that** the first (3a) and/or second (3b) touch-sensitive button is formed by a slider.

6. The control device (1) according to one of claims 3 to 5, **characterized in that** the length of the respective touch-sensitive button (3a, 3b) approximately corresponds to the length of the respective adjacent peripheral edge of the display unit (2) .

7. The control device (1) according to one of claims 1 to 6, **characterized in that** an additional touch-sensitive button (6) for the activation or deactivation of the control device (1) is arranged close to the display unit (2).

8. The control device (1) according to one of claims 1 to 7, **characterized in that** an additional touch-sensitive button (8) for starting beverage dispensing and/or for activating or deactivating a programming/set-up menu of the control device (1) is arranged close to the display unit (2), preferably in the region of the first (3a) and second (3b) touch-sensitive buttons facing each other.

9. The control device (1) according to one of claims 1 to 8, **characterized in that** the mode of operation shown on the display unit (2) after selection by the appropriate touch-sensitive button (3a, 3b) is optically generated, in particular in an increased and/or three-dimensional manner.

10. The control device (1) according to one of claims 1 to 9, **characterized in that** the illuminated symbols (5a, 5b, 7) consist in an arrow or a hand with an index finger as a direction arrow.

## Revendications

1. Dispositif de commande (1) pour appareils électriques, en particulier machines à café, comprenant au moins une unité d'entrée et une unité d'affichage (2) ayant la fonction choisie au moyen de l'unité d'entrée, le dispositif de commande (1) permettant d'activer des diverses fonctions par l'actionnement d'éléments de commutation correspondants à l'appareil électrique, l'unité d'entrée ayant deux boutons tactiles (3a, 3b) qui sont disposés près de l'unité d'affichage (2) et sont utilisés pour la sélection des fonctions (4a, 4b, 4c, 4d, 4e) montrées à l'unité d'affichage (2), en outre le premier bouton tactile (3a) sélectionnant une fonction (4a, 4b, 4c, 4d, 4e) montrée à l'unité d'affichage (2), et le deuxième bouton tactile (3b) confirmant ou optionnellement variant la fonction (4a, 4b, 4c, 4d, 4e), **caractérisé en ce qu'**au dispositif de commande (1) de l'unité d'affichage (2) et aux boutons tactiles (3a, 3b), des symboles (5a, 5b, 7) illuminés, indépendants sont disposés près des boutons tactiles (3a, 3b) ou au moins partiellement recouvrant les boutons tactiles (3a, 3b) qui dirigent l'attention de l'utilisateur sur les boutons tactiles (3a, 3b).

2. Dispositif de commande (1) selon la revendication 1, **caractérisé en ce que** les boutons tactiles (3a, 3b) sont réalisés par des capteurs tactiles capacitifs.

3. Dispositif de commande (1) selon la revendication 1 ou 2, **caractérisé en ce que** l'unité d'affichage (2) a une forme environ rectangulaire, le côté long du rectangle étant disposé environ en parallèle à un premier bord périphérique du boîtier du dispositif et le côté court du rectangle étant disposé environ en parallèle à un deuxième bord périphérique du boîtier du dispositif (1), dans lequel le premier bouton tactile (3a) est disposé environ en parallèle au premier bord périphérique et le deuxième bouton tactile (3b) est disposé environ en parallèle au deuxième bord périphérique de l'unité d'affichage (2) rectangulaire, de préférence est tout proche.

4. Dispositif de commande (1) selon la revendication 3, **caractérisé en ce que** les boutons (3a, 3b) voisins sont disposés dans une zone de coin, de préférence la zone de coin avant à la droite dirigée vers l'utilisateur, de l'unité d'affichage (2) environ rectangulaire.

5. Dispositif de commande (1) selon une des revendications 1 à 4, **caractérisé en ce que** le premier (3a) et/ou deuxième (3b) bouton tactile est réalisé par un slider.

6. Dispositif de commande (1) selon une des revendications 3 à 5, **caractérisé en ce que** la longueur du bouton tactile (3a, 3b) respectif environ correspond à la longueur du bord périphérique voisin respectif de l'unité d'affichage (2).

7. Dispositif de commande (1) selon une des revendications 1 à 6, **caractérisé en ce qu'**un bouton tactile (6) additionnel pour l'activation ou la désactivation du dispositif de commande (1) est disposé près de l'unité d'affichage (2).

8. Dispositif de commande (1) selon une des revendications 1 à 7, **caractérisé en ce qu'**un bouton tactile (8) additionnel pour le démarrage de la distribution de boisson et/ou pour l'activation ou la désactivation d'un menu de programmation/réglage du dispositif de commande (1) est disposé près de l'unité d'affichage (2), de préférence dans la zone du premier (3a) et deuxième (3b) bouton tactile étant en vis-à-vis.

9. Dispositif de commande (1) selon une des revendications 1 à 8, **caractérisé en ce que** le mode fonctionnel montré à l'unité d'affichage (2) après la sélection par le bouton tactile (3a, 3b) approprié est généré de manière optique, en particulier de manière augmentée et/ou tridimensionnelle.

10. Dispositif de commande (1) selon une des revendications 1 à 9, **caractérisé en ce que** les symboles (5a, 5b, 7) illuminés consistent en une flèche ou une main avec l'index comme flèche directionnelle.
